# EUROPEAN PATENT SPECIFICATION

(11) **EP 3 951 487 B1**
(45) Date of publication and mention of the grant of the patent: **29.11.2023**
(21) Application number: 21195917.6
(22) Date of filing: 22.08.2019
(51) Int. Cl.: G02F 1/1333, G06F 1/16, G09F 9/30

(54) **DISPLAY DEVICE INCLUDING BASE FILM**
ANZEIGEVORRICHTUNG MIT BASISFILM
DISPOSITIF D'AFFICHAGE COMPRENANT UN FILM DE BASE

(30) Priority: 24.08.2018 KR 20180099347
(43) Date of publication of application: 09.02.2022
(62) Divisional of application: 19192989.2
(73) Proprietor: Samsung Display Co., Ltd., Gyeonggi-do 17113 (KR)
(72) Inventor: Ha, Seung-Hwa, 405 Hwaseong-si, Gyeonggi-do (KR); Ahn, Sung Sang, 303-13 Hwaseong-si, Gyeonggi-do (KR); Lee, Jung Hun, 407-1604 Hwaseong-si, Gyeonggi-do (KR); Kim, Kyu Young, 634-703 Suwon-si, Gyeonggi-do (KR)
(74) Representative: Dr. Weitzel & Partner

(56) References cited:
- EP-A1- 3 521 914
- KR-A- 20180 088 556
- US-A1- 2015 102 324

## Description

### BACKGROUND

### (a) Field

The present disclosure relates to a display device and a manufacturing method of a base film included in the display device.

### (b) Description of the Related Art

The field of display technology has been rapidly developed for various information transfer means in modern society. Within the field of display technology, many technical challenges have been recognized in terms of weight and thickness of a display device for which a structure thereof moves away from flat-panel light emission of the display device.

In general, as a display device, a liquid crystal display ("LCD"), an organic light emitting diode ("OLED") display, etc., are used. To apply these display devices to various applications within the field of display technology, a flexible display device that may be relatively easily bent has been developed.

As one of the flat panel displays, the liquid crystal display is most widely used. Since the liquid crystal display is a non-emissive display device, there is a drawback in that a separate light source such as a backlight is used to provide light to the liquid crystal display. An organic light emitting diode ("OLED") display that is a self-luminous display device has received attention. The organic light emitting diode display includes two electrodes facing each other, and an organic layer interposed between the electrodes. In the organic light emitting diode display, if holes injected from an anode and electrons injected from a cathode meet each other at a light emitting layer disposed between two electrodes to generate an exciton, and the exciton is subjected to photo-luminescence quenching, light is generated. The organic light emitting diode display may be applied to various display technology fields including a display device and a lighting device. The following documents represent prior art relevant to the present invention: EP3521914 A1 and US 2015/102324 A1.

### SUMMARY

The invention has been made in an effort to provide a display device that may reduce damage to components thereof when the display device and/or the components thereof are bent, and a manufacturing method of a base film not using an adhesive layer, the method not being part of the claimed invention.

An exemplary embodiment of the invention provides a display device including: a display panel including a flexible substrate; and a base film disposed on the display panel. The base film includes a first polymer layer and a second polymer layer each having a multilayered structure, and a metal layer disposed between the first polymer layer and the second polymer layer.

The first polymer layer and the second polymer layer may include a polyimide material, respectively.

The first polymer layer or the second polymer layer includes a first layer and a second layer, the first layer may be disposed between the second layer and the metal layer, and the first layer and the second layer may include different materials.

The second layer may include polyimide, and the first layer may include at least one of polyurethane, polyphenylene sulfide, polyethylene naphthalate, polyarylene ether ketone, polyethylene, triacetyl cellulose, polyamide, polyethylene terephthalate, and perylene.

A thickness of the first layer may be about 4 micrometers (µm) to about 10 µm.

A thickness of the second layer may be about 4 µm to about 20 µm.

A thickness ratio of a thickness of the first layer to a thickness of the second layer may be about 1:1 to about 1:5.

The metal layer may include at least one of Invar, stainless steel, titanium, a nickel alloy, a copper alloy, an amorphous metal, and a composite metal.

A thickness of the metal layer may be about 30 µm or less.

A thickness ratio of a thickness of the metal layer to a thickness of the first polymer layer may be about 1:3 or less.

The display device including the display panel may be bendable in a direction which applies a compressive force to the display panel and in a direction which applies a tensile force to the display panel.

Another embodiment not according to the claimed invention provides a display device including:
a display panel including a flexible substrate; and a base film disposed on the display panel.. The base film includes a first film layer and a second film layer overlapping each other, a metal layer disposed between the first film layer and the second film layer, at least one of adhesive layer disposed between the first film layer and the metal layer or between the second film layer and the metal layer. the adhesive layer includes a polymer layer and an adhesive material layer which is disposed on both of opposing surfaces of the polymer layer, respectively.

Within the adhesive layer, the polymer layer may include at least one of polyimide, polyethylene terephthalate, polyethylene naphthalate, polyamide, polyphenylene sulfide, and polyarylene ether ketone.

Each of the first film layer and the second film layer may include at least one of polyimide, polyurethane, polyphenylene sulfide, polyethylene naphthalate, polyarylene ether ketone, polyethylene, triacetyl cellulose, polyamide, polyethylene terephthalate, and perylene.

Within the adhesive layer, a thickness of the polymer layer may be larger than a thickness of the adhesive material layer.

A total thickness of the adhesive layer may be about 4 µm to about 5 µm.

Yet another embodiment not according to the claimed invention provides a manufacturing method of a base film, including: preparing a metal layer: providing a first coating layer on opposite surfaces of the metal layer; and providing a second coating layer on the first coating layer to provide the first coating layer between the metal layer and the second coating layer. The first coating layer may include at least one of polyimide, polyurethane, polyphenylene sulfide, polyethylene naphthalate, polyarylene ether ketone, polyethylene, triacetyl cellulose, polyethylene terephthalate, and perylene, and the second coating layer may include polyimide. Solely providing the first coating layer between the metal layer and the second coating layer adheres the metal layer to the second coating layer.

A thickness of the first coating layer may be about 4 µm to about 10 µm.

A thickness of the second coating layer may be about 4 µm to about 20 µm.

A thickness of the metal layer may be about 30 µm or less.

Another embodiment not according to the claimed invention provides a manufacturing method of a base film, including: preparing a metal layer: providing a first film and a second film on opposite surfaces of the metal layer, respectively; applying heat between the metal layer and the first film and between the metal layer and the second film to melt surfaces of the metal layer, the first film, and the second film; and applying a pressure to the metal layer, the first film, and the second film to which the heat is applied. Solely applying the heat and the pressure attaches the first film and the metal layer to each other, and attaches the second film and the metal layer to each other.

Each of the first film layer and the second film layer may include at least one of polyimide, polyurethane, polyphenylene sulfide, polyethylene naphthalate, polyarylene ether ketone, polyethylene, triacetyl cellulose, polyamide, polyethylene terephthalate, and perylene.

The metal layer may include at least one of Invar, stainless steel, titanium, a nickel alloy, a copper alloy, an amorphous metal, and a composite metal.

The applying the heat between the metal layer and the first film and between the metal layer and the second film may be performed at a temperature of about 100 degrees Celsius to about 150 degrees Celsius.

According to one or more embodiment of the invention, a display device including a base film is provided which reduces damage from repeated bending thereof, and a manufacturing method of a base film is provided not using an adhesive layer within the base film.

### BRIEF DESCRIPTION OF THE DRAWINGS

The above and other advantages and features of this disclosure will become more apparent by describing in further detail exemplary embodiments thereof with reference to the accompanying drawings, in which:
FIG. 1 illustrates a cross-sectional view of an exemplary embodiment of a display device according to the invention.
FIG. 2 illustrates an enlarged cross-sectional view of an exemplary embodiment of a base film in the display device of FIG. 1.
FIG. 3 and FIG. 4 illustrate exemplary embodiments of flexible display devices according to the invention.
FIG. 5 and FIG. 6 illustrate exemplary embodiments of foldable display devices according to the invention.
FIG. 7 illustrates an enlarged cross-sectional view of another exemplary embodiment of a base film not according to the claimed invention.
FIG. 8 to FIG. 10 are cross-sectional views of processes of an exemplary embodiment of a manufacturing method of a base film not according to the claimed invention.
FIG. 11 to FIG. 14 are cross-sectional view of processes of another exemplary embodiment of a manufacturing method of a base film not according to the claimed invention.
FIG. 15 schematically illustrates a cross-sectional view of another exemplary embodiment of a display device according to the invention.
FIG. 16 illustrates a top plan view of an exemplary embodiment of a display panel of a display device according to the invention, and FIG. 17 illustrates a cross-sectional view taken along line XVII-XVII' of the display device of FIG. 16.
FIG. 18 is an enlarged cross-sectional view of another exemplary embodiment of a display panel of a display device according to the invention.

### DETAILED DESCRIPTION

The invention will be described more fully hereinafter with reference to the accompanying drawings, in which exemplary embodiments of the invention are shown. As those skilled in the art would realize, the described embodiments may be modified in various different ways.

Parts that are irrelevant to the description will be omitted to clearly describe the present disclosure, and like reference numerals designate like elements throughout the specification.

Further, in the drawings, the size and thickness of each element are arbitrarily illustrated for ease of description, and the present disclosure is not necessarily limited to those illustrated in the drawings. In the drawings, the thicknesses of layers, films, panels, regions, etc., are exaggerated for clarity. In the drawings, for ease of description, the thicknesses of some layers and areas are exaggerated.

It will be understood that when an element such as a layer, film, region, or substrate is referred to as being related to another element such as being "on" another element, it can be directly on the other element or intervening elements may also be present. In contrast, when an element is referred to as being related to another element such as being "directly on" another element, there are no intervening elements present. Further, in the specification, the word "on" means positioned above or below the object portion, and does not necessarily mean positioned on the upper side of the object portion based on a gravitational direction.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. In addition, unless explicitly described to the contrary, the word "comprise" and variations such as "comprises" or "comprising" will be understood to imply the inclusion of stated elements but not the exclusion of any other elements.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Further, throughout the specification, the phrase "on a plane" means viewing a target portion from the top (e.g., in a top plan view), and the phrase "on a cross-section" means viewing a cross-section formed by vertically cutting a target portion from the side.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In an organic light emitting diode display or a liquid crystal display, a flexible display device can be configured by using a bendable base substrate. In this case, constituent elements such as pixels and/or wires of the flexible display device which are disposed on the base substrate may have bent or folded portions which may be deformed or of which the characteristics may be deteriorated due to stress.

Hereinafter, one or more embodiment of a display device according to the invention, and one or more embodiment of a manufacturing method of a base film included in the display device, will be described in detail with reference to the drawings.

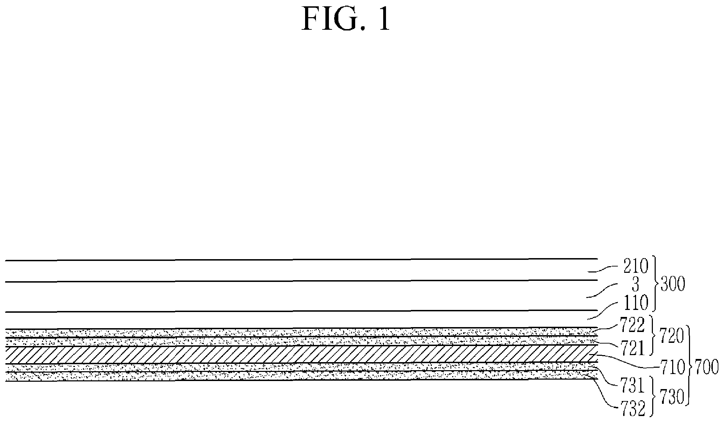

FIG. 1 schematically illustrates a cross-sectional view of an exemplary embodiment of a display device according to the invention. Referring to FIG. 1, a display device according to an exemplary embodiment of the invention includes a base film 700 having a multilayer structure and a display panel 300 which is disposed on the base film 700. The display device and components thereof may be disposed in a plan defined by a first direction and a second direction which cross each other. In FIG. 1, the horizontal direction may represent the first direction and/or the second direction. A thickness of the display device and components thereof is defined along a third direction which crosses each of the first and second directions. In FIG. 1, the vertical direction represents the third (e.g., thickness) direction of the display device and components thereof.

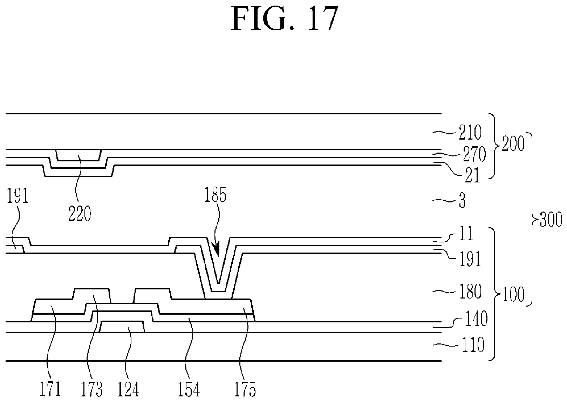

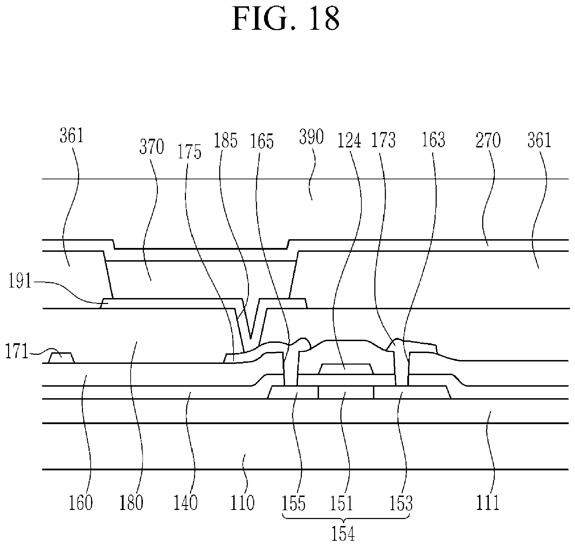

Referring to FIG. 1, the display panel 300 may include a first (display) substrate 110, a second (display) substrate 210, and a light transmittance control layer such as a liquid crystal layer 3 interposed therebetween. However, this structure is merely an example, and the display panel 300 may be a light emitting display device that does not include the liquid crystal layer 3 but includes a light emitting element (e.g., is self-emissive). That is, a kind of the display panel 300 is not limited. However, the display panel 300 includes the first substrate 110 in which transistors and the like are disposed. As will be described later in detail, the display panel 300 may have a cross-sectional structure as shown in FIG. 17 or FIG. 18.

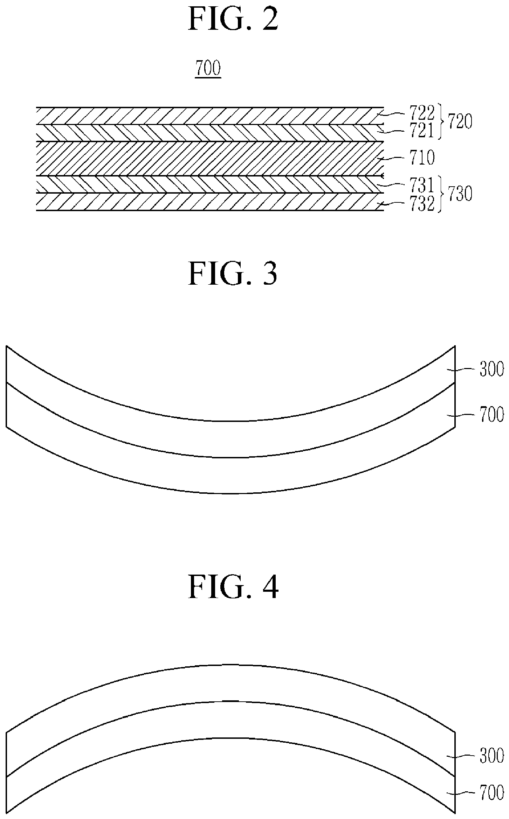

FIG. 2 illustrates an enlarged cross-sectional view of an exemplary embodiment of a base film of the display device of FIG. 1. Referring to FIG. 2, the base film 700 includes a metal layer 710, and a first polymer layer 720 and a second polymer layer 730 respectively disposed on opposite sides of the metal layer 710. The metal layer 710 may include at least one of Invar, stainless steel, titanium, a nickel alloy, a copper alloy, an amorphous metal, and a composite metal. However, this is only an example, and the materials of the metal layer 710 are not limited thereto.

The first polymer layer 720 includes a first layer 721 and a second layer 722, and the first layer 721 is disposed between the second layer 722 and the metal layer 710. Similarly, the second polymer layer 730 includes a first layer 731 and a second layer 732, and the first layer 731 is disposed between the second layer 732 and the metal layer 710. The second layers 722 and 732 each define an outer surface of the base film 700. Any one or more of the first and second layers 721, 722, 731 and 732 may be referred to as a "sub-layer" or a "sub-polymer layer" within the first polymer layer 720 and the second polymer layer 730, respectively. Any one or more among the first and second layers 721, 722, 731 and 732 may be defined as a single-layered layer.

Hereinafter, the first polymer layer 720 will be mainly described, but the description of the first polymer layer 720 is applicable to the second polymer layer 730 as well. The first layer 721 and the second layer 722 may contact each other to form an interface therebetween. In an exemplary embodiment, such contact or interface may effectively provide an adhesive force between the layers to attach the second layer 722 to the metal layer 710 solely by the first layer 721 therebetween.

The first layer 721 of the first polymer layer 720 may include at least one of polyimide, polyurethane, polyphenylene sulfide, polyethylene naphthalate, polyarylene ether ketone, polyethylene, triacetyl cellulose, polyamide, polyethylene terephthalate, and perylene. The second layer 722 of the first polymer layer 720 may include at least one of polyimide, polyurethane, polyphenylene sulfide, polyethylene naphthalate, polyarylene ether ketone, polyethylene, triacetyl cellulose, polyamide, polyethylene terephthalate, and perylene. In an exemplary embodiment, for example, the second layer 722 may include polyimide.

According to the claimed invention, adhesion between the first layer 721 and the metal layer 710 is superior (e.g., stronger, more reliable, etc.) to that between the second layer 722 and the metal layer 710. In an exemplary embodiment, for example, the interfacial adhesion between the first layer 721 and the metal layer 710 is equal to and greater than about 1000 grams force per inch (gf/in), and the second layer 722 may have an adhesion of about 800 gf/in, which is relatively lower than interfacial adhesion between the first layer 721 and the metal layer 710. However, the interfacial adhesion between layers may vary depending on a material thereof, and in particular, adhesion between a metal and a polymer may be lower than that between the same materials. That is, a material of a layer may contribute to or provide an adhesive force relative to another layer. Therefore, the interfacial adhesion between the first layer 721 and the metal layer 710 as described above should maintain relatively high adhesion so that interfacial exfoliation does not occur between such layers even if the display device is folded.

A cross-sectional thickness of the first layer 721 may be about 4 micrometers (µm) to about 10 µm. In an exemplary embodiment, a thickness of a layer may contribute to or provide an adhesive force relative to another layer. When the thickness of the first layer 721 is less than about 4 µm, interfacial exfoliation thereof relative to other layers may occur due to relatively weak adhesion, and when the thickness of the first layer 721 is more than about 10 µm, buckling of the first layer 721 or a layer relative thereto may occur. The thickness of a layer may be taken in a direction normal to an upper surface and/or a lower surface of the first layer 721, at any of a number of positions along the first layer 721. Such consideration of the thickness may be hereinafter applied to any layer within the display device and components thereof.

A cross-sectional thickness of the second layer 722 may be about 4 µm to about 20 µm. When the thickness of the second layer 722 is less than about 4 µm, there may be yield strain and fatigue fracture on the material of the second layer 722 due to folding, deformation, etc., thereof. When the thickness of the second layer 722 is more than about 20 µm, there is a problem that buckling is caused due to a tensile stress increase and a bending stiffness increase.

In an exemplary embodiment, for example, a thickness ratio of the thickness of the first layer 721 to the thickness of the second layer 722 may be about 1:1 to about 1:5 which is a maximum ratio. When the thickness ratio is less than about 1:1, stress may be transferred to the metal layer 710 by the yield strain and fatigue fracture on the material of one or more of the first and second layers 721 and 722 due to the folding. When the thickness range is more than about 1:5, the buckling may occur due to relatively weaker interfacial adhesion between the metal layer 710 and one or more of the first and second layers 721 and 722 due to an increase in bending rigidity during the folding, or material breakage may occur due to an increase in tensile stress applied to the material.

The description of the second polymer layer 730 is the same as that of the first polymer layer 720. The first layer 731 and the second layer 732 may contact each other to form an interface therebetween. In an exemplary embodiment, such contact or interface may effectively provide an adhesive force between the layers to attach the second layer 732 to the metal layer 710 solely by the first layer 731 therebetween. The first layer 731 of the second polymer layer 730 may include at least one of polyimide, polyurethane, polyphenylene sulfide, polyethylene naphthalate, and polyarylene ether ketone. The second layer 732 of the second polymer layer 730 may also include at least one of polyimide, polyurethane, polyphenylene sulfide, polyethylene naphthalate, and polyarylene ether ketone. In an exemplary embodiment, for example, the second layer 732 may include polyimide.

In this case, adhesion between the first layer 731 and the metal layer 710 is superior to that between the second layer 732 and the metal layer 710. In an exemplary embodiment, for example, the adhesion between the first layer 731 and the metal layer 710 is equal to and greater than about 1000 gf/in, and the second layer 732 may have adhesion of about 800 gf/in, which is relatively lower than interfacial adhesion between the first layer 731 and the metal layer 710. However, the interfacial adhesion between layers may vary depending on a material thereof, and in particular, adhesion between a metal and a polymer may be lower than that between the same materials. That is, a material of a layer may contribute to or provide an adhesive force relative to another layer. Therefore, the interfacial adhesion between the first layer 731 and the metal layer 710 as described above should maintain relatively high adhesion so that interfacial exfoliation does not occur between such layers even if the display device is folded.

A cross-sectional thickness of the first layer 731 may be about 4 µm to about 10 µm. When the thickness of the first layer 731 is less than about 4 µm, an interfacial exfoliation thereof relative to other layers may occur due to relatively weak adhesion, and when the thickness of the first layer 731 is more than about 10 µm, buckling of the first layer 721 or a layer relative thereto may occur.

A cross-sectional thickness of the second layer 732 may be about 4 µm to about 20 µm. When the thickness of the second layer 732 is less than about 4 µm, there may be yield strain and fatigue fracture on the material of the second layer 732 due to folding, deformation, etc., thereof. When the thickness of the second layer 732 is more than about 20 µm, there is a problem that buckling is caused due to a tensile stress increase and a bending stiffness increase.

In an exemplary embodiment, for example, a thickness ratio of the thickness of the first layer 731 to the thickness of the second layer 732 may be about 1:1 to about 1:5 which is a maximum ratio. When the thickness ratio is less than about 1:1, stress may be transferred to the metal layer 710 by the yield strain and fatigue fracture on the material of one or more of the first and second layers 731 and 732 due to the folding. When the thickness range is more than about 1:5, the buckling may occur due to relatively weaker interfacial adhesion between the metal layer 710 and one or more of the first and second layers 731 and 732 due to an increase in bending rigidity during the folding, or material breakage may occur due to an increase in tensile stress applied to the material.

The metal layer 710 may include at least one of Invar, stainless steel, titanium, a nickel alloy, a copper alloy, an amorphous metal, and a composite metal, but is not limited thereto.

Among the aforementioned materials, the Invar is an alloy of iron and nickel, specifically, an alloy having about 63.5 % of iron and about 36.5 % of nickel and having a relatively small thermal expansion coefficient. Invar is preferable as a material of the metal layer 710 as being relatively easy to process in a form of a metal layer or film, as having a relatively high modulus (about 58.8 gigapascals (GPa), and as having a moisture absorption rate of about 0%. The stainless steel may be SUS 304 or SUS 301, but is not limited thereto.

The metal layer 710 serves not only to balance the display device such as to support or maintain an overall shape thereof, but also to support the display panel 300 within the display device and to reduce or effectively prevent damage to the display device and/or components thereof from external impacts. However, stress may be concentrated on the metal layer 710 when the display device is repeatedly bent. Therefore, when a base film of a display device is formed as a single layer including only a metal material layer, the single metal material layer of the base film may be broken when the display device is repeatedly bent.

However, one or more exemplary embodiment of the base film 700 of the display device according to the invention includes the metal layer 710, the first polymer layer 720 and the second polymer layer 730 that respectively contact opposite sides of the metal layer 710 to form interfaces therewith, and the first polymer layer 720 and the second polymer layer 730 each have a multi-layered structure. The first polymer layer 720 and the second polymer layer 730 each having a multilayer structure may solve the problem of breakage or damage to the base film 700 in a repeatedly folded area thereof when the display device is bent. That is, the first polymer layer 720 and the second polymer layer 730 including the polymer material may increase the yield strain at which the base film 700 begins to break, thereby reducing or effectively preventing damage to the base film 700 even when the display device is repeatedly bent.

The first polymer layer 720 is formed as a multilayer structure including the first layer 721 and the second layer 722, and the second polymer layer 730 is formed as a multilayer structure including the first layer 731 and the second layer 732. The first layer 721 of the first polymer layer 720 and the first layer 731 of the second polymer layer 730 each have superior adhesion to the metal layer 710 compared to the second layers thereof relative to the metal layer 710. Therefore, the metal layer 710 and the second layer 722 of the first polymer layer 720, and the metal layer 710 and the second layer 732 of the second polymer layer 730, may be attached to each other without using any adhesive or adhesive layer. Instead, solely the first layer 721 of the first polymer layer 720 and solely the first layer 731 of the second polymer layer 730 may be used to attach the metal layer 710 to the second layer 722 of the first polymer layer 720, and the metal layer 710 to the second layer 732 of the second polymer layer 730, respectively.

When an adhesive or an adhesive layer is used inside a base film such as the base film 700, the base film 700 is affected at an interface of the adhesive or the adhesive layer with layers contacted thereto. Also, defects may exist on a surface of the metal layer 710 included in the base film 700, and the adhesive or the adhesive layer may not solve (e.g., assist in minimizing) the defects. Such a surface defect of the metal layer 710 or the like becomes a point where damage is started when the base film 700 is repeatedly bent.

However, in one or more embodiment of the display device and the base film 700 according to the invention, a separate adhesive or adhesive layer is not used. Instead, each polymer layer includes a first layer and a second layer, where the first layer closest to the metal layer 710 functions as an adhesive to bond the second layer to the metal layer 710. That is, the first layer may solely attach the metal layer 710 to the second layer. In this case, the first layer including a polymer material may solve the defects on the surface of the metal layer 710. That is, the first layer including the polymer material fills or is disposed at a surface defect location to effectively solve the defect at the surface of the metal layer 710, thereby reducing or effectively preventing the damage to the base film 700 and improving reliability thereof and of the display panel, the display device, etc. using such base film 700.

In addition, since the polymer layer included in the base film 700 includes the first layer and the second layer having different physical properties from each other, the physical properties may complement each other in terms of a chemical characteristic, a mechanical characteristic, a physical characteristic, etc. In an exemplary embodiment, for example, the first and second layers may include materials having different moduli from each other. The modulus of the metal layer 710 and the modulus of the polymer layer are different from each other, and the base film 700 may be damaged by the modulus difference. However, when the first layer and the second layer of the polymer layer contain materials having different moduli, and the first layer closest to the metal layer 710 has a similar modulus to that of the metal layer 710 relative to the second layer, the damage may be reduced or effectively prevented.

FIG. 3 and FIG. 4 illustrate exemplary embodiments of flexible display devices according to the invention. FIG. 3 illustrates that a flexible display device having components of the base film 700 and the display panel 300 is bent in a direction to apply a compressive force to the display panel 300 and elements thereof, and FIG. 4 illustrates that a flexible display device having components of the base film 700 and the display panel 300 is bent in a direction to apply a tensile force to the display panel 300 to essentially stretch the display panel 300 and elements thereof. That is, as shown in FIG. 3 and FIG. 4, the display device according to one or more exemplary embodiment of a display device according to the invention may be bent in both directions including the direction in which the display panel 300 is stretched and the direction in which the display panel 300 is compressed.

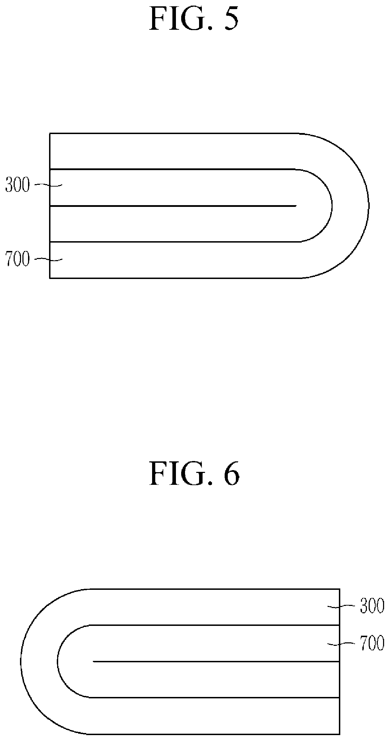

FIG. 5 and FIG. 6 illustrate exemplary embodiments of foldable display devices according to the invention. FIG. 5 illustrates that a foldable display device having components of the base film 700 and the display panel 300 is bent in the direction in which the display panel 300 is compressed, and FIG. 6 illustrates that a foldable display device having components of the base film 700 and the display panel 300 is bent in the direction in which the display panel 300 is stretched. That is, as shown in FIG. 5 and FIG. 6, one or more exemplary embodiment of a display device according to the invention may be folded in both directions including the direction in which the display panel 300 is stretched and the direction in which the display panel 300 is compressed.

In one or more exemplary embodiment of a display device according to the invention, the base film 700 includes the metal layer 710, and the first polymer layer 720 and the second polymer layer 730 that are respectively in contact with opposite sides of the metal layer 710, where the first polymer layer 720 and the second polymer layer 730 have multi-layered structures and do not include separate adhesive layers or adhesives. Thus, even when the display device is bent or folded in various directions thereof, damage to the base film 700 may be reduced or effectively prevented, and reliability thereof may be improved.

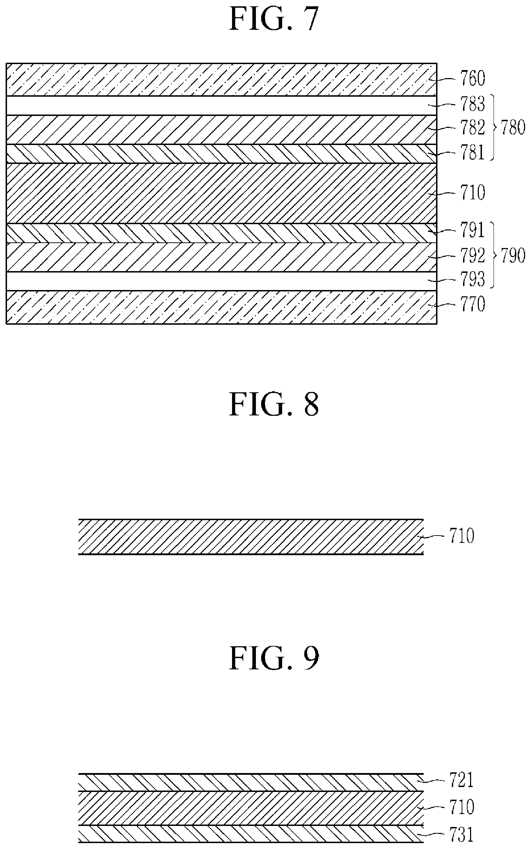

Hereinafter, a base film 700 according to another exemplary embodiment not according to the claimed invention will be described. FIG. 7 illustrates another exemplary embodiment of the base film 700 not according to the claimed invention. Referring to FIG. 7, the base film 700 includes the metal layer 710, a first film layer 760 and a second film layer 770 on opposite sides of the metal layer 710, a first adhesive layer 780 disposed between the metal layer 710 and the first film layer 760, and a second adhesive layer 790 disposed between the metal layer 710 and the second film layer 770. The first film layer 760 and the second film layer 770 each define an outer surface of the base film 700.

The first adhesive layer 780 may contact each of the first film layer 760 and the metal layer 710 to form respective interfaces therebetween. Similarly, the second adhesive layer 790 may contact each of the second film layer 770 and the metal layer 710 to form respective interfaces therebetween. In an exemplary embodiment, such contact or interface between the first adhesive layer 780 and the first film layer 760 (or the second adhesive layer 790 and the second film layer 770 may effectively provide an adhesive force between the layers to attach the film layer to the metal layer 710 solely by the adhesive layer therebetween. As similarly described above with respect to FIG. 2, an adhesion between the first adhesive layer 780 (or the second adhesive layer 790) and the metal layer 710 may be superior (e.g., stronger, more reliable, etc.) relative to that between the first film layer 760 (or the second film layer 770) and the metal layer 710.

A description of the metal layer 710 is the same as in the previous exemplary embodiment. That is, the metal layer 700 may include at least one of Invar, stainless steel, titanium, a nickel alloy, a copper alloy, an amorphous metal, and a composite metal, but is not limited thereto. A cross-sectional thickness of the metal layer 710 may be about 30 µm or less. A thickness ratio of a thickness of the metal layer 710 to a thickness of the first polymer layer 720 may be about 1:3 or less.

The cross-sectional thickness of the metal layer 710 is in a range in which stress is not increased in the display device having a predetermined curvature. However, when the curvature of the display device is reduced or a size of the display device to be manufactured is large, the thickness of the metal layer 710 may be about 30 µm or more. The metal layer 710 having the thickness of about 30 µm or less is suitable for a relatively small display device such as a mobile display device or personal electronic device. A thickness ratio of a thickness of the metal layer 710 to a thickness of the first polymer layer 720 may be about 1:3 or less.

The first film layer 760 and the second film layer 770 may include at least one of polyimide, polyurethane, polyphenylene sulfide, polyethylene naphthalate, polyarylene ether ketone, polyethylene, triacetyl cellulose, polyamide, polyethylene terephthalate, and perylene, respectively. Cross-sectional thicknesses of the first film layer 760 and the second film layer 770 may each be about 4 µm to about 10 µm, respectively.

The first adhesive layer 780 may have a three-layered structure of a first adhesive material layer 781/a polymer layer 782/a second adhesive material layer 783. Similarly, the second adhesive layer 790 may have a three-layered structure of a first adhesive material layer 791/a polymer layer 792/a second adhesive material layer 793. Any one of the layers 781, 782, 783, 791, 792 and 793 may be referred to as a "sub-layer" or a "sub-polymer layer" within the first adhesive layer 780 and the second adhesive layer 790, respectively. Any one or more among the layers 781, 782, 783, 791, 792, 793, 760 and 770 may be defined as a single-layered layer.

In the first adhesive layer 780, the polymer layer 782 may include at least one of polyimide, polyethylene terephthalate, polyether naphthalate, polyamide, polyphenylene sulfide, and polyarylene ether ketone. In an exemplary embodiment, for example, the polymer layer 782 may include polyethylene terephthalate.

Similarly, in the second adhesive layer 790, the polymer layer 792 may include at least one of polyimide, polyethylene terephthalate, polyether naphthalate, polyamide, polyphenylene sulfide, and polyarylene ether ketone. In an exemplary embodiment, for example, the polymer layer 792 may include polyethylene terephthalate.

In the first adhesive layer 780, a thickness of the polymer layer 782 may be larger than each of those of the first adhesive material layer 781 and the second adhesive material layer 783. Similarly, in the second adhesive layer 790 a thickness of the polymer layer 792 may be larger than each of those of the first adhesive material layer 791 and the second adhesive material layer 793. Since within each of the first adhesive layer 780 and the second adhesive layer 790, the thickness of the polymer layer is larger than both adhesive layers, the first adhesive layer 780 and the second adhesive layer 790 may be maintained at an overall thickness of more than a predetermined thickness and may be relatively easily handled in a process of manufacturing or use thereof.

In an exemplary embodiment, respective total thicknesses of the first adhesive layer 780 and the second adhesive layer 790 may be about 4 µm to about 5 µm. When a total thickness of the first adhesive layer 780 and/or the second adhesive layer 790 are less than about 4 µm, adhesion between the metal layer 710 and the first film layer 760 may not be sufficient, thus these layers may not be easily handled in a process or manufacturing or use thereof. When a total thickness of the first adhesive layer 780 and/or the second adhesive layer 790 exceeds about 5 µm, a thickness of the composite layer becomes relatively thick as a whole, and stress may be transferred to a laminated display module including such composite layer, causing fatigue and cracking during folding of the display module.

In the base film according to the exemplary embodiment of FIG. 7, the first adhesive layer 780 and the second adhesive layer 790 include a polymer layer therein. In this case, the polymer layer may offset a modulus difference between the metal layer 710 and the first adhesive layer 780, and between the metal layer 710 and the second adhesive layer 790.

That is, when the first adhesive layer 780 and the second adhesive layer 790 do not include the polymer layer but include only an adhesive material layer, the base film 700 may be easily damaged due to a modulus difference between the adhesive material layer and the metal layer 710. However, in one or more exemplary embodiment of a display device according to the invention, the base film may include the polymer layers inside the first adhesive layer 780 and the second adhesive layer 790 to compensate for the modulus difference. The polymer layer within the adhesive layer has a modulus similar to that of the metal layer 710 as compared to the adhesive material layer within the adhesive layer.

Hereinafter, a manufacturing method of the base film not according to the claimed invention will be described. FIG. 8 to FIG. 10 are cross-sectional views of processes of an exemplary embodiment of a manufacturing method of a base film. Referring to FIG. 8, the metal layer 710 is prepared. In this case, the metal layer 700 may include or be formed of at least one of Invar, stainless steel, titanium, a nickel alloy, a copper alloy, an amorphous metal, and a composite metal.

A total cross-sectional thickness of the metal layer 710 may be about 30 µm or less.

Referring to FIG. 9, first coating layers 721 and 731 are respectively formed or provided on opposite surfaces of the metal layer 710. The first coating layers 721 and 731 may be disposed on the opposite surfaces of the metal layer 710 so as to contact the respective opposite surfaces of the metal layer 710 and form respective interfaces therebetween. The first coating layers 721 and 731 may include or be formed of a same material as each other.

Respective total thicknesses of the first coating layers 721 and 731 may be about 4 µm to about 10 µm. The first coating layers 721 and 731 may include at least one of polyimide, polyurethane, polyphenylene sulfide, polyethylene naphthalate, polyarylene ether ketone, polyethylene, triacetyl cellulose, polyethylene terephthalate, and perylene, respectively.

The first coating layers 721 and 731 may be formed by coating a coating material corresponding to at least one of polyimide, polyurethane, polyphenylene sulfide, polyethylene naphthalate, polyarylene ether ketone, polyethylene, triacetyl cellulose, polyethylene terephthalate, and perylene on a surface of the metal layer 710, and then drying the coating material layer.

In this case, the first coating layers 721 and 731 may solve defects at an outer surface of the metal layer 710. That is, when defects such as cracks exist at the surface of the metal layer 710, the first coating layers 721 and 731 may be filled in positions in which the defects exist to as to effectively solve or cure such surface defects.

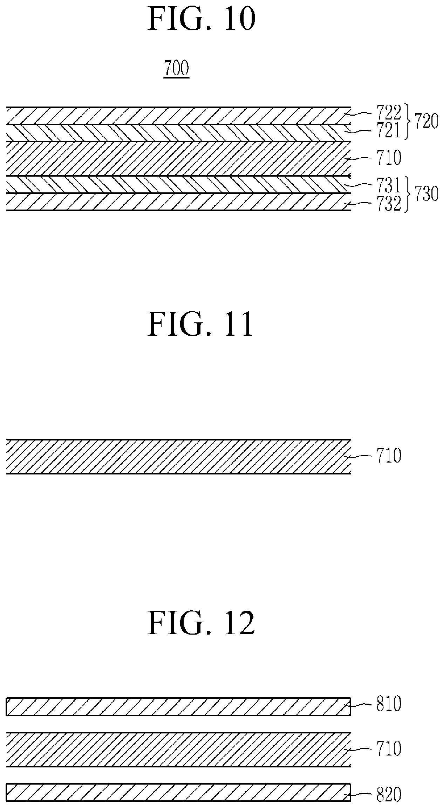

Referring to FIG. 10, second coating layers 722 and 732 are formed or provided on the first coating layers 721 and 731, respectively. Thicknesses of the second coating layers 722 and 732 may be about 4 µm to about 20 µm. The second coating layers 722 and 732 may include at least one of polyimide, polyurethane, polyphenylene sulfide, polyethylene naphthalate, polyarylene ether ketone, polyethylene, triacetyl cellulose, polyethylene terephthalate, and perylene, respectively.

As such, the base film 700 illustrated in FIG. 2 may be completed, where second coating layers 722 and 732 form outer surfaces of the base film 700. Here, the base film 700 may be manufactured without using an adhesive or an adhesive layer solely by sequentially forming the coating layers. That is, solely providing the first layer 721 between the second layer 722 and the metal layer 710, and solely providing the first layer 731 between the second layer 732 and the metal layer 710 may attach the metal layer 710 to the second layer 722, and attach the metal layer 710 to the second layer 732, respectively.

The first coating layers 721 and 731 have greater adhesion relatively to the metal layer 710 than to the second coating layers 722 and 732. Therefore, in the manufacturing method of the base film 700 according to the one or more exemplary embodiment, the metal layer 710 and the second coating layers 722 and 732 including a polymer material may be bonded to each other via the first coating layers 721 and 731, without using a separate adhesive or a separate adhesive layer. Since the first coating layers 721 and 731 also solve or cure defects at the outer surface of the metal layer 710, damage to the base film 700 may be reduced or effectively prevented, and reliability may be improved.

Hereinafter, a manufacturing method of the base film according to another exemplary embodiment not according to the claimed invention will be described. FIG. 11 to FIG. 14 are cross-sectional views of another exemplary embodiment of a manufacturing method of a base film 700.

The manufacturing method of the base film according to another exemplary embodiment includes preparing the metal layer 710, disposing a first film 810 and a second film 820 on opposite surfaces of the metal layer, melting surfaces of the metal layer 710, the first film 810, and the second film 820 by applying heat between the metal layer 710 and the first film 810 and between the metal layer 710 and the second film 820, and attaching the first film 810 and the metal layer 710 and the second film 820 and the metal layer 710 by applying pressure to the metal layer 710, the first film 810, and the second film 820.

Referring to FIG. 11, the metal layer 710 is prepared. In this case, the metal layer 710 may include or be formed of at least one of Invar, stainless steel, titanium, a nickel alloy, a copper alloy, an amorphous metal, and a composite metal. A total cross-sectional thickness of the metal layer 710 may be 30 µm or less.

Referring to FIG. 12, a first film 810 and a second film 820 are respectively disposed on opposite surfaces of the metal layer 710.

In this case, the first film 810 and the second film 820 may include at least one of polyimide, polyurethane, polyphenylene sulfide, polyethylene naphthalate, polyarylene ether ketone, polyethylene, triacetyl cellulose, polyamide, polyethylene terephthalate, and perylene. Total cross-sectional thicknesses of the first film and the second film may be about 4 µm to about 20 µm, respectively.

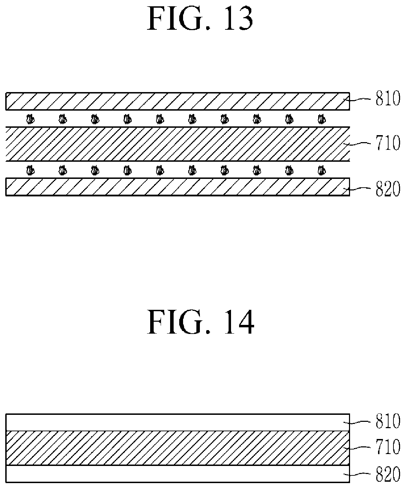

Referring to FIG. 13, heat is applied to the layers 810, 710 and 820 such that heat is applied at an interface between the metal layer 710 and the first film 810 and at an interface between the metal layer 710 and the second film 820, which essentially melts the surfaces of the metal layer 710, the first film 810, and the second film 820.

Heating may be performed at a temperature of about 100 degrees Celsius to about 150 degrees Celsius.

Referring to FIG. 14, pressure is applied to the metal layer 710, the first film 810, and the second film 820 which are heated, to attach the first film 810 and the metal layer 710 to each other and to attach the second film 820 and the metal layer 710 to each other. Since one or more among the surfaces of the metal layer 710 which face the first and second films 810 and 820, and the surfaces of the first film 810 and the second film 820 which face the metal layer 710, are melted by the heating in the previous process, the metal layer 710 and the first film 810 and the metal layer 710 and the second film 820 are attached to each other only by the pressure applied to heated layers in the present process without a separate adhesive. Therefore, the metal layer 710, and the first and second films 810 and 820 including the polymer material, may be bonded to each other solely by the application of heating and pressure and without using an adhesive or an adhesive layer separate to the metal layer 710, the first film 810, and the second film 820.

Referring to the method in FIG. 11 to FIG. 14, the first film 810 and/or the second film 820 may include a layer 721 or 731 (FIG. 2), a layer 720 or 730 (FIG. 2), a layer 780 or 790 (FIG. 7) or a collective layer 780 plus 760 or a collective layer 790 plus 770 (FIG. 7), without being limited thereto.

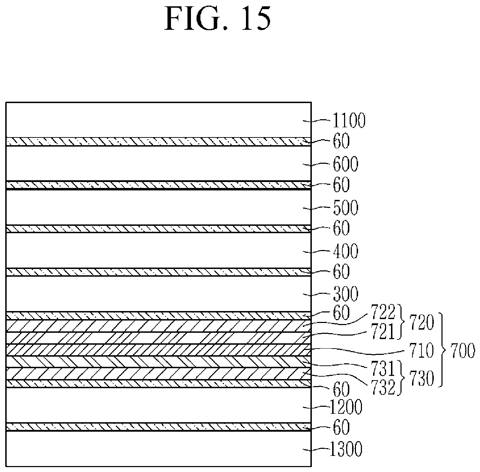

Hereinafter, an overall stacked structure of a display device according to another exemplary embodiment of the invention will be described. FIG. 15 schematically illustrates a cross-sectional view of another exemplary embodiment of a display device according to the invention.

Referring to FIG. 15, for a display device according to the exemplary embodiment of the invention, the display device may be fixed by a jig 1300. A cover panel 1200 may be disposed on the jig 1300 and have a cushion structure. As elements of the display device, the base film 700 is disposed on the cover panel 1200, the display panel 300 is disposed on the base film 700, a polarizing plate 400 is disposed on the display panel 300, a touch panel 500 is disposed on the polarizing plate 400, a window 600 is disposed on the touch panel 500, and a passivation film 1100 is disposed on the window 600. Respective elements among those of the display device, the jig 130 and the cover panel 1200 may be bonded to each other by an adhesive layer 60. In an embodiment, the jig 1300 and the cover panel 1200 may be considered as an element of the display device, but are not limited thereto.

The structure shown in FIG. 15 is an example, and the stacked order of the elements may be changed and/or some elements may be omitted. Referring to FIG. 15, the display panel 300 is disposed in a central area of the display device along a thickness direction of the overall stacked structure, on the base film 700. In addition, since the base film 700 includes the metal layer 710 having a relatively high modulus, a neutral surface of the display device may be formed in the display panel 300. As used herein, the neutral surface (or a neutral plane) may be a conceptual plane within the stacked structure that, when loaded by a bending force, the stacked structure may bend so that the inner surface is in compression and the outer surface is in tension. As the base film 700 includes the metal layer 710, and the first polymer layer 720 and the second polymer layer 730 respectively disposed on opposite sides of the metal layer 710, damage to the metal layer 710 by repeated bending thereof may be reduced or effectively prevented.

The first polymer layer 720 includes the first layer 721 and the second layer 722, and the first layer 721 is disposed between the second layer 722 and the metal layer 710. Similarly, the second polymer layer 730 includes the first layer 731 and the second layer 732, and the first layer 731 is disposed between the second layer 732 and the metal layer 710.

In this case, the first layer 721 of the first polymer layer 720 and the first layer 731 of the second polymer layer 730 each function as an adhesive layer, and thus a separate adhesive layer is not included to bond adjacent layers to each other within the base film 700. Accordingly, surface defects of the metal layer 710 may be cured or solved by the first layer 721 of the first polymer layer 720 disposed on or in the surface defects, and the first layer 731 of the second polymer layer 730 disposed on or in the surface defects, thereby reducing or effectively preventing damage to the base film 700 and improving reliability thereof.

In FIG. 15, the base film 700 has the structure of FIG. 2, but the base film 700 of FIG. 15 may have the structure of FIG. 7, which is not according to the claimed invention.

In the foregoing description, the display panel 300 may be a liquid crystal display panel or a light emitting display panel, but is not limited thereto. However, the display panel 300 includes the first substrate 110 (refer to FIG. 1), and particularly, when the display device is a flexible display device, the first substrate 110 may be flexible.

Hereinafter, a specific structure that may be applied to the display panel 300 will be described with reference to the accompanying drawings.

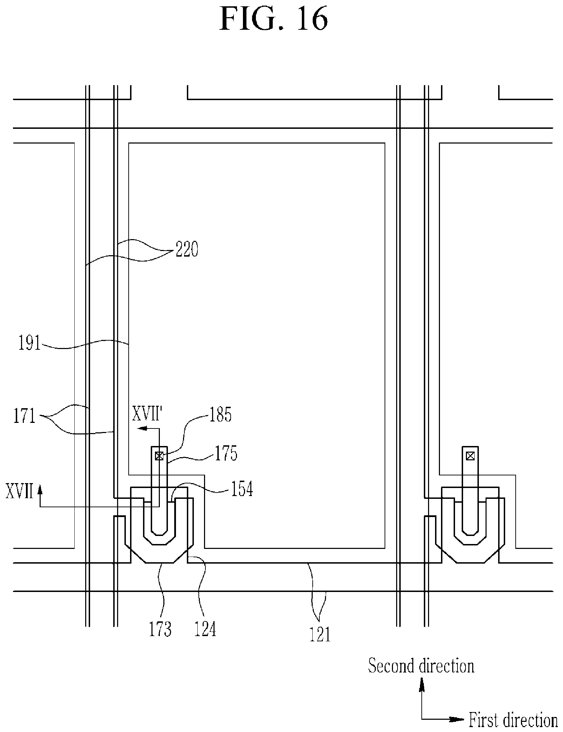

FIG. 16 illustrates a top plan view of an exemplary embodiment of a display panel of a display device according to the invention, and FIG. 17 illustrates a cross-sectional view taken along line XVII-XVII' of the display panel of FIG. 16.

Referring to FIG. 16 and FIG. 17, the display panel 300 includes a first display panel (substrate) 100, a second display panel (substrate) 200 overlapping the first display panel 100 along a thickness direction of the display panel (and the display device), and a light transmittance control layer such as a liquid crystal layer 3 disposed between the first display panel 100 and the second display panel 200.

First, the first display panel 100 will be described. A gate conductor (layer) including a gate line 121 and a gate electrode 124 is disposed on a surface of the first substrate 110. The first substrate 110 may include or made of transparent glass or plastic.

The gate line 121 may lengthwise extend in a first direction. The gate conductor may include various metal materials or conductive materials, and may have a multi-layered structure. A gate insulating film 140 is disposed between the gate conductor and the liquid crystal layer 3. The gate insulating film 140 may include an inorganic insulating material.

A semiconductor layer 154 is disposed on a surface of the gate insulating film 140.

A data line 171 is disposed between the semiconductor layer 154 and the liquid crystal layer 3, lengthwise extends in a second direction, and crosses the gate line 121. A source electrode 173 may extend from or be defined by a portion of the data line 171 and overlap the gate electrode 124. A drain electrode 175 may be separated from the data line 171, and may have a bar shape in the top plan view which extends toward a center of the source electrode 173 as shown in FIG. 16.

A portion of the semiconductor layer 154 may not overlap the data line 171 and the drain electrode 175 in a region between the source electrode 173 and the drain electrode 175. The semiconductor layer 154 may have substantially the same planar shape in the top plan view as the data line 171 and the drain electrode 175, except for the portion that does not overlap the source electrode 173 and the drain electrode 175.

One gate electrode 124, one source electrode 173, and one drain electrode 175 may form one switching element such as a thin film transistor together with the semiconductor layer 154. A channel of the thin film transistor corresponds to a region of the semiconductor layer 154 between the source electrode 173 and the drain electrode 175.

A passivation film 180 is disposed between each of the source electrode 173 and drain electrode 175, and the liquid crystal layer 3, respectively. The passivation film 180 may include an inorganic insulating material such as a silicon nitride or a silicon oxide, an organic insulating material, a relatively low dielectric constant insulating material, and the like.

The passivation film 180 is provided with a contact hole 185 which overlaps a portion of the drain electrode 175 to expose such portion.

A first electrode 191 is disposed between the passivation film 180 and the liquid crystal layer 3. The first electrode 191 is physically and electrically connected to the drain electrode 175 at the contact hole 185, and receives a data voltage from the drain electrode 175. The first electrode 191 may be a pixel electrode.

A first alignment layer 11 is disposed between the first electrode 191 and the liquid crystal layer 3.

The second display panel 200 includes a second substrate 210, a light blocking member 220, a second electrode 270, and a second alignment layer 21.

The second electrode 270 is disposed on a surface of the second substrate 210. The second electrode 270 may be a common electrode.

The light blocking member 220 is disposed between the second substrate 210 and the second electrode 270. The light blocking member 220 may overlap the data line 171 and lengthwise extend in the second direction. Although not shown, the light blocking member may further include a horizontal portion overlapping the gate line 121 and lengthwise extending in the first direction. However, in an exemplary embodiment, the light blocking member 220 may be omitted.

The second alignment layer 21 is disposed between the second electrode 270 and the liquid crystal layer 3.

Hereinafter, a display panel of a display device according to another exemplary embodiment of the invention will be described in detail with reference to FIG. 18.

FIG. 18 is a cross-sectional view of another exemplary embodiment of a display panel of a display device according to the invention. Referring to FIG. 18, a buffer layer 111 including or made of a silicon oxide or a silicon nitride is disposed on the first substrate 110.

The semiconductor layer 154 is disposed on the buffer layer 111. The semiconductor layer 154 includes a source region 153 and a drain region 155 doped with p-type impurities, and includes a channel region 151 disposed between the source region 153 and the drain region 155. Each of the regions of the semiconductor layer 154 may be formed from or may be portions of a same material layer having differently-doped areas.

The gate insulating film 140 is disposed on the semiconductor layer 154 and the buffer layer 111, and may include a silicon oxide or a silicon nitride. The gate electrode 124 overlaps the channel region 151 of the semiconductor layer 154, and is disposed on the gate insulating film 140.

An interlayer insulating film 160 is disposed on the gate electrode 124 and the gate insulating film 140. The interlayer insulating film 160 is provided with a first contact hole 165 and a second contact hole 163.

A data conductor including the data line 171, the source electrode 173 and the drain electrode 175 is disposed on the interlayer insulating film 160.

The drain electrode 175 is connected to the drain region 155 at the first contact hole 165. The source electrode 173 is connected to the source region 153 at the second contact hole 163.

The passivation film 180 is disposed on the data conductor elements 171, 173, and 175 and the interlayer insulating film 160, and the passivation film 180 is provided with the contact hole 185.

The first electrode 191 is disposed on the passivation film 180. The first electrode 191 may be a pixel electrode. The first electrode 191 is connected to the drain electrode 175 at the contact hole 185. A partition wall 361 is disposed on the passivation film 180. A light emitting material layer 370 (e.g., a light-emitting diode layer) is disposed to overlap the first electrode 191, and the second electrode 270 is disposed to overlap the light emitting diode layer 370. The second electrode 270 may be a common electrode.

In this case, the first electrode 191 may be an anode which is a hole injection electrode, and the second electrode 270 may be a cathode which is an electron injection electrode. However, these layers are not limited thereto. In an exemplary embodiment, according to a driving method of the display device, the first electrode 191 may be a cathode and the second electrode 270 may be an anode.

The light-emitting layer 370 may include a light emission layer, an electron transporting layer, a hole transporting layer, etc. Together, the first electrode 191, the second electrode 270 and the light-emitting layer 370 may for a light-emitting diode of the display panel 300, such that the display panel 300 self-emits light within the display device.

An encapsulation layer 390 is positioned to overlap the second electrode 270. The encapsulation layer 390 may include an organic material or an inorganic material, or may include the organic material and the inorganic material that are alternately stacked. The encapsulation layer 390 may protect elements of the display panel from external moisture, heat, and other pollutants which can degrade the performance or reliability of such elements.

In an exemplary embodiment of a display device, the display panel 300 of FIGS. 16 and 17 or of FIG. 18 is disposed in a central area of the overall display device along a thickness direction thereof, on the base film 700. As such, a central layer of the display device may be disposed within the display panel 300, such that a neutral surface of the display device may be formed in the display panel 300. The base film 700 and other components (refer to FIG. 15) may be disposed below the display panel 300 such that the central layer of the display device may be disposed within the display panel 300.

As described above, one or more exemplary embodiment of the display device according to the invention includes the base film 700 positioned below the display panel 300, and the base film 700 has a structure in which the metal layer 710 is positioned between the first polymer layer 720 and the second polymer layer 730 each including the polymer material. Accordingly, the central layer of the display device is disposed at the display panel 300 by the metal layer 710 within the base film 700, so that damage to the display panel 300 is minimized even when the display device is bent.

The first polymer layer 720 and the second polymer layer 730 have a multi-layered structure, and one layer in the multi-layered structure may solely adhere a respective one of the first polymer layer 720 and the second polymer layer 730 to the metal layer 710. Therefore, damage to the base film 700 due to defects on the surface of the metal layer 710 are essentially cured or solved by the first polymer layer 720 and the second polymer layer 730 without including any further adhesive or adhesive layer.

In addition, the base film of a display device may be manufactured without using an adhesive or an adhesive layer by sequentially forming the coating layers. According to another exemplary embodiment of the invention, the base film may be manufactured without using an adhesive or an adhesive layer by heating the metal layer and the film layer to melt the surfaces thereof and then pressing them.

## Claims

1. A display device comprising:
a display panel (300) including a flexible substrate;
a base film (700) disposed on the display panel (300);
wherein the base film (700) comprises a first and a second film layer (720, 730) having each a multilayered structure;
the base film (700) further comprises a metal layer (710) that is disposed between the first and the second film layers (720, 730) and
the first film layer (720) or the second film layer (730) include a first layer (721, 731) and a second layer (722, 732);
the first layer (721, 731) is disposed between the second layer (722, 732) and the metal layer (710) and has an interface with the metal layer (710);
**characterized in that** the first and second film layers (720, 730) are polymer layers and **in that** an interfacial adhesion between the material of the first layer (721, 731) and the metal layer (710) is stronger than an interfacial adhesion between the material of the second layer (722, 732) and the metal layer (710).

2. The display device of claim 1, wherein
the first and the second film layers (720, 730) each include a polyimide material.

3. The display device of one of claims 1 or 2, wherein:
the first and the second layers (721, 731, 722, 732) include different materials.

4. The display device of claim 3, wherein
the second layer (732) includes polyimide, and
the first layer (731) includes at least one of polyurethane, polyphenylene sulfide, polyethylene naphthalate, polyarylene ether ketone, polyethylene, triacetyl cellulose, polyamide, polyethylene terephthalate, and perylene.

5. The display device of one of claims 3 to 4, wherein
a thickness of the first layer (731) is about 4 micrometers to about 10 micrometers.

6. The display device of one of claims 3 to 5, wherein
a thickness of the second layer (732) is about 4 micrometers to about 20 micrometers.

7. The display device of one of claims 3 to 6, wherein
a thickness ratio of a thickness of the first layer (731) to a thickness of the second layer (732) is about 1:1 to about 1:5.

8. The display device of one of claims 1 to 7, wherein
the metal layer (710) includes at least one of Invar, stainless steel, titanium, a nickel alloy, a copper alloy, an amorphous metal, and a composite metal.

9. The display device of one of claims 1 to 8, wherein
a thickness of the metal layer (710) is about 30 micrometers or less.

10. The display device of claim 1, wherein
a thickness ratio of a thickness of the metal layer (710) to a total thickness of the first film layer (720) is about 1:3 or less.

11. The display device of one of claims 1 to 10, wherein
each of the first film layer (720) and the second film layer (730) includes at least one of polyimide, polyurethane, polyphenylene sulfide, polyethylene naphthalate, polyarylene ether ketone, polyethylene, triacetyl cellulose, polyamide, polyethylene terephthalate, and perylene.

## Patentansprüche

1. Anzeigevorrichtung, umfassend:
ein Anzeigefeld (300), einschließend ein flexibles Substrat;
einen Basisfilm (700), der auf dem Anzeigefeld (300) angeordnet ist;
wobei der Basisfilm (700) eine erste und eine zweite Filmschicht (720, 730) umfasst, die jeweils eine mehrschichtige Struktur aufweisen,
der Basisfilm (700) ferner eine Metallschicht (710) umfasst, die zwischen der ersten und der zweiten Filmschicht (720, 730) angeordnet ist,
und die erste Filmschicht (720) oder die zweite Filmschicht (730) eine erste Schicht (721, 731) und eine zweite Schicht (722, 732) beinhaltet;
die erste Schicht (721, 731) zwischen der zweiten Schicht (722, 732) und der Metallschicht (710) angeordnet ist und eine Grenzfläche mit der Metallschicht (710) aufweist;
**dadurch gekennzeichnet, dass**
die erste und die zweite Filmschicht (720, 730) Polymerschichten sind und dass eine Grenzflächenhaftung zwischen dem Material der ersten Schicht (721, 731) und der Metallschicht (710) stärker ist als eine Grenzflächenhaftung zwischen dem Material der zweiten Schicht (722, 732) und der Metallschicht (710).

2. Anzeigevorrichtung nach Anspruch 1, wobei
die erste und die zweite Filmschicht (720, 730) jeweils ein Polyimidmaterial einschließen.

3. Anzeigevorrichtung nach einem der Ansprüche 1 oder 2, wobei:
die erste und die zweite Schicht (721, 731, 722, 732) unterschiedliche Materialien einschließen.

4. Anzeigevorrichtung nach Anspruch 3, wobei
die zweite Schicht (732) Polyimid einschließt und
die erste Schicht (731) mindestens eines von Polyurethan, Polyphenylensulfid, Polyethylennaphthalat, Polyarylenetherketon, Polyethylen, Triacetylcellulose, Polyamid, Polyethylenterephthalat und Perylen einschließt.

5. Anzeigevorrichtung nach einem der Ansprüche 3 bis 4, wobei
eine Dicke der ersten Schicht (731) ungefähr 4 Mikrometern bis ungefähr 10 Mikrometern entspricht.

6. Anzeigevorrichtung nach einem der Ansprüche 3 bis 5, wobei
eine Dicke der zweiten Schicht (732) ungefähr 4 Mikrometern bis ungefähr 20 Mikrometern entspricht.

7. Anzeigevorrichtung nach einem der Ansprüche 3 bis 6, wobei
ein Dickenverhältnis einer Dicke der ersten Schicht (731) zu einer Dicke der zweiten Schicht (732) ungefähr 1:1 bis ungefähr 1:5 entspricht.

8. Anzeigevorrichtung nach einem der Ansprüche 1 bis 7, wobei
die Metallschicht (710) mindestens eines von Invar, Edelstahl, Titan, einer Nickellegierung, einer Kupferlegierung, einem amorphen Metall und einem Verbundmetall einschließt.

9. Anzeigevorrichtung nach einem der Ansprüche 1 bis 8, wobei
eine Dicke der Metallschicht (710) ungefähr 30 Mikrometern oder weniger entspricht.

10. Anzeigevorrichtung nach Anspruch 1, wobei
ein Dickenverhältnis einer Dicke der Metallschicht (710) zu einer Gesamtdicke der ersten Filmschicht (720) ungefähr 1:3 oder weniger entspricht.

11. Anzeigevorrichtung nach einem der Ansprüche 1 bis 10, wobei
jede von der ersten Filmschicht (720) und der zweiten Filmschicht (730) mindestens eines von Polyimid, Polyurethan, Polyphenylensulfid, Polyethylennaphthalat, Polyarylenetherketon, Polyethylen, Triacetylcellulose, Polyamid, Polyethylenterephthalat und Perylen einschließt.

## Revendications

1. Dispositif d'affichage comprenant :
un panneau d'affichage (300) comportant un substrat flexible ;
un film de base (700) disposé sur le panneau d'affichage (300) ;
dans lequel le film de base (700) comprend une première et une seconde couche de film (720, 730) ayant une structure multicouche,
le film de base (700) comprend en outre une couche de métal (710) qui est disposée entre les première et seconde couches de film (720, 730) et
la première couche de film (720) ou la seconde couche de film (730) inclut une première couche (721, 731) et une seconde couche (722, 732) ;
la première couche (721, 731) est disposé entre la seconde couche (722, 732), et la couche de métal (710) et a une interface avec la couche de métal (710) ;
**caractérisé en ce que** les première et seconde couches de film (720, 730) sont des couches de polymère et **en ce qu'**une adhérence interfaciale entre le matériau de la première couche (721, 731) et la couche de métal (710) est plus forte qu'une adhérence interfaciale entre le matériau de la seconde couche (722, 732) et la couche de métal (710).

2. Dispositif d'affichage selon la revendication 1, dans lequel
les première et seconde couches de film (720, 730) comportent chacune un matériau de polyimide.

3. Dispositif d'affichage selon l'une des revendications 1 ou 2, dans lequel :
la première et la seconde couches (721, 731, 722, 732) comportent des matériaux différents.

4. Dispositif d'affichage selon la revendication 3, dans lequel
la seconde couche (732) comporte du polyimide, et
la première couche (731) comporte au moins l'un parmi le polyuréthane, le polysulfure de phénylène, le polynaphtalate d'éthylène, la polyarylène éther cétone, le polyéthylène, la triacétyl cellulose, le polyamide, le polytéréphtalate d'éthylène, et le pérylène.

5. Dispositif d'affichage selon l'une des revendications 3 et 4, dans lequel
une épaisseur de la première couche (731) est d'environ 4 micromètres à environ 10 micromètres.

6. Dispositif d'affichage selon l'une des revendications 3 à 5, dans lequel
une épaisseur de la seconde couche (732) est d'environ 4 micromètres à environ 20 micromètres.

7. Dispositif d'affichage selon l'une des revendications 3 à 6, dans lequel
un rapport d'épaisseur entre une épaisseur de la première couche (731) et une épaisseur de la seconde couche (732) est d'environ 1:1 à environ 1:5.

8. Dispositif d'affichage selon l'une des revendications 1 à 7, dans lequel
la couche de métal (710) comporte au moins l'un parmi l'invar, l'acier inoxydable, le titane, un alliage de nickel, un alliage de cuivre, un métal amorphe, et un métal composite.

9. Dispositif d'affichage selon l'une des revendications 1 à 8, dans lequel
une épaisseur de la couche de métal (710) est d'environ 30 micromètres ou moins.

10. Dispositif d'affichage selon la revendication 1, dans lequel
un rapport d'épaisseur entre une épaisseur de la couche de métal (710) et une épaisseur totale de la première couche de film (720) est d'environ 1:3 ou moins.

11. Dispositif d'affichage selon l'une des revendications 1 à 10, dans lequel
chacune de la première couche de film (720) et de la seconde couche de film (730) comporte au moins l'un parmi le polyimide, le polyuréthane, le polysulfure de phénylène, le polynaphtalate d'éthylène, la polyarylène éther cétone, le polyéthylène, la triacétyl cellulose, le polyamide, le polytéréphtalate d'éthylène, et le pérylène.
